# EUROPÄISCHE PATENTANMELDUNG

(11) **EP 2 645 119 A1**
(43) Veröffentlichungstag der Anmeldung: **02.10.2013**
(21) Anmeldenummer: 13161942.1
(22) Anmeldetag: 02.04.2013
(51) Int. Cl.: G01R 33/561

(54) **Verfahren für schnelle Spin-Echo MRT Bildgebung**

(30) Priorität: 30.03.2012 EP 12162485; 02.04.2012 EP 12162861; 12.06.2012 EP 12171685
(71) Anmelder: Max-Delbrück-Centrum für Molekulare Medizin Berlin-Buch, 13125 Berlin (DE)
(72) Erfinder: Niendorf, Thoralf, 52074 Aachen (DE); Hezel, Fabian, 10435 Berlin (DE); Klix, Sabrina, 16359 Biesenthal (DE)
(74) Vertreter: Lange, Sven

(57) **Zusammenfassung**

Die Erfindung betrifft ein Magnetresonanztomographie-Verfahren, wobei nach einer Grundanregung und einer Serie von Hochfrequenz-Refokussierungspulsen nach dem Spin-Echo Prinzip zwei Echogruppen entstehen, wobei beide Echogruppen unabhängig voneinander phasenkodiert werden, und wobei die Rekonstruktion für beide Echogruppen unabhängig voneinander erfolgt.

## Beschreibung

Die Erfindung betrifft ein Magnetresonanztomographie-Verfahren, wobei nach einer Grundanregung und einer Serie von Hochfrequenz-Refokussierungspulsen nach dem Spin-Echo Prinzip zwei Echogruppen entstehen, wobei beide Echogruppen unabhängig voneinander phasenkodiert werden, und wobei die Rekonstruktion für beide Echogruppen unabhängig voneinander erfolgt.

### Stand der Technik

Die klinische Magnetresonanz (MR)-Bildgebung basiert auf der Anregung von Wasserstoffprotonen. Nach dem "Bohrschen Atommodell" ist das Proton eines Wasserstoffatoms positiv geladen und ein negativ geladenes Elektron kreist räumlich um das Proton.

Das Proton eines Wasserstoffatoms besitzt einen Eigendrehimpuls, einen sogenannten Spin. Der Spin erzeugt einen magnetischen Dipol, daher richtet sich ein Wasserstoffatom in einem Magnetfeld aus und kann von einem elektromagnetischen Hochfrequenzfeld angeregt werden. Die Protonen richten sich entlang eines statischen Magnetfeldes B₀ aus und präzessieren. Die Präzessionsbewegung besitzt eine charakteristische Frequenz, die Larmorfrequenz, welche proportional zur Stärke des Magnetfeldes ist (Weishaipt, Kächeli und Marincek, Wie funktioniert MRT? Heidelberg: Springer-Verlag, 2009. S. 1-23).

Der erste Schritt in der MR-Bildgebung ist die schichtselektive Anregung. Während der Anregung durch einen Hochfrequenzimpuls wird zusätzlich ein Gradientenfeld in entsprechender Richtung erzeugt, wodurch die Präzessionsfrequenz entlang dieser Richtung variiert. Es ist möglich, durch Änderung der lokalen Magnetfeldstärke, Schichten eines abzubildenden Objektes definiert auszuwählen und von diesem ein entsprechendes 2D-Bild zu erstellen. Nach Anregung mit entsprechenden Gradientenfeldern besitzt das Magnetfeld einen Gradienten - einen Anstieg - entlang der Z-Richtung. Jede Schicht entlang der Z-Richtung erhält eine eigene Frequenz. Die Larmorfrequenz regt nur die entsprechende Schicht an (Weishaipt, Kächeli und Marincek, 2009).

Benachbarte Schichten werden nicht angeregt, da die Frequenz des Spins (Rotationsfrequenz) nicht der Larmorfrequenz entspricht und keine Resonanz erzeugt wird.

Die Schichtdicke wird durch die Gradientenstärke definiert. Nach der Anregung einer Schicht werden die elektromagnetischen Signale gemessen. Diese Signale sind ein Gemisch aus unterschiedlichen Frequenzen, die von verschiedenen Volumenelementen abgestrahlt werden. Für die räumliche Zuordnung der Signale ist eine weitere Kodierung der Y- und X-Dimension erforderlich.

Die Ortskodierung, die auf die Schichtselektion folgt, ist auf die ausgewählte Schicht beschränkt. Dies geschieht durch Schalten von zusätzlichen Gradientenfeldern, um die einzelnen Datenpunkte der X- und Y-Koordinaten zu bestimmen. Die Ortskodierung des MR-Signals innerhalb der angeregten Schicht beruht auf einer Zerlegung der Bildinhalte in einzelne Ortsfrequenzkomponenten. Ein Phasenkodiergradient wird entlang der Y-Richtung aufgebaut. Der Gradient besitzt einen Anstieg entlang der Y-Richtung. Die Protonen sind durch die Schichtselektion bereits ausgerichtet und rotieren in der X-Y-Ebene. Durch den zugeschalteten Phasenkodiergradienten rotieren die Protonen mit höherer Larmorfrequenz schneller als Protonen mit geringerer Frequenz. Es entsteht eine Phasenverschiebung der Protonen. Jede Zeile der definierten Schicht kann durch ihre Phase eindeutig identifiziert werden. Mit einem Frequenzgradienten G*_{X}* entlang der X-Koordinate wird das Signal frequenzkodiert. Die Protonen verhalten sich wie bei der Phasenkodierung. Durch die Überlagerung der Phasen- und Frequenzkodierung ist jedes Volumenelement (Voxel) eindeutig lokalisierbar. Die Gradienten G*_{Z}*, G*_{Y}* und G*_{X}* überlagern sich mit dem Hauptmagnetfeld B₀ (Weishaipt, Kächeli und Marincek, 2009).

Die empfangenen Signale entsprechen einer Zeile im k-Raum. Die Messung wird mit jeweils veränderter Amplitude des Phasenkodiergradienten G*_{Y}* wiederholt, wodurch eine weitere Zeile im k-Raum erstellt wird. Durch eine inverse zweidimensionale (2D-) Fast-Fourier Transformation der Daten erhält man das Schnittbild.

Eine Sequenz ist eine Kombination aus der zeitlichen Folge von Hochfrequenzpulsen (von 90°- und 180°-Pulsen) und Gradientenfeldern mit entsprechender Stärke, die mehrfach pro Sekunde in vorgegebener Reihenfolge erzeugt werden. Die Spinecho-Sequenz ist gegen die Heterogenität des B₀ Feldes relativ unempfindlich. Die Sequenz basiert auf einer Abfolge eines 90°- und eines 180°-Impulses. Free Induction Decay (FID) stellt den Induktionsabfall des MR-Signals dar. Nach einem 90°-Impuls präzessieren die Spins in Phase. Sie fächern sich in der X-Y-Ebene auf und laufen mit unterschiedlicher Geschwindigkeit auseinander (Dephasierung). Nach einer Laufzeit von τ wird ein 180°-Impuls erzeugt. Die Spins drehen sich um 180° um die Y-Achse. Diese kommen wieder in Phase (Rephasierung). Nach einer Laufzeit von 2τ erreicht das Spinecho-Signal sein Maximum, danach fällt das Spinecho wieder ab. Dieser Zeitraum wird als Echozeit (TE) bezeichnet (Magnete, Spins und Resonanzen, Erlangen: Siemens AB (Hrsg.) 2009).

Die kardiovaskuläre MR-Bildgebung erfordert eine sehr schnelle Datenaufnahmegeschwindigkeit, um Bewegungsartefakte des Herzens zu minimieren. Eine Synchronisation mit dem Herzzyklus ist erforderlich, um den Einfluss der Kontraktion auf die Bildqualität zu reduzieren. Eine Echtzeitbildgebung ist nur unter limitierter Bildqualität möglich (Strohm, Bernhard, Niendorf: Kardiovaskuläre MRT in der Praxis. München: Urban und Fischer, 2006. S. 3 - 17). Die segmentierte Akquise der MR-Daten ermöglicht die Minimierung der Artefakte durch Kontraktion und Blutfluss. Die Datenerfassung erfolgt dabei über mehrere Herzzyklen. In jedem Herzzyklus wird nur eine begrenzte Anzahl von k-Raum-Daten aufgenommen. Mit einer verringerten Auflösung ist eine Video-Darstellung (CINE-view) des kontrahierenden Herzens möglich. Pro Herzzyklus und Herzphase werden jeweils drei Datenzeilen aufgenommen bis die Rohdaten im k-Raum vollständig erstellt sind. Mit der inversen Fast-Fourier-Transformation erhält man das 2D-Bild.

Die MR-Bildgebung lässt sich anhand zweier grundsätzlich verschiedener Verfahren beschleunigen. Schnelle Bildgebungstechniken akquirieren mehrere Echos innerhalb einer Sequenz. Als eine schnelle Sequenz wird die Turbo-Spinecho-Sequenz (TSE) vorgestellt. Das zweite Verfahren basiert auf eine reduzierte Aufnahme von Datenzeilen. Durch die Unterabtastung entstehen Einfaltungsartefakte, die einer Korrektur bedürfen.

Die Turbo-Spinecho-Sequenzen (TSE) beruhen auf mehreren Refokussierungen (Echozug) der initialen Anregung, um ein vollständiges Bild zu erstellen. Durch eine Grundanregung mit einem 90° Puls und anschließenden Zug von 180° Pulsen wird ein Echozug erzeugt. Jedes Echo der Serie erhält eine andere Phasenkodierung und füllt eine Zeile der Rohdatenmatrix. Den maximalen Zeitgewinn bestimmt die Länge des Echozuges. Je kürzer der Echozug, umso weniger Bildpunkte können aufgenommen werden (Weishaipt, Kächeli und Marincek, 2009).

Bei der Turbo-Spinecho-Sequenz entstehen ab dem zweiten Echo des Echozuges stimulierte Echos. Diese werden mit den üblichen Echos überlagert. Die Auslesegradienten wurden entsprechend angepasst, dass die Echos auseinander geschoben wurden, so dass bei der Datenaufnahme jeweils zwei Echos in jeder k-Raumzeile vorhanden sind. Die Zentren der Echos liegen bei 1/4 und 3/4 des Akquisitionsfensters.

Durch vier Hochfrequenzimpulse mit je 180°, werden vier Echos erzeugt. Der G*_{Y}* Gradient muss für jedes Echo mit jeweils veränderter Amplitude erneut erzeugt. Mit den unterschiedlichen Phasenkodierungen erhält man vier Zeilen im k-Raum (Weishaipt, Kächeli und Marincek, 2009). Mit dieser Sequenz werden die Daten segmentweise abgelegt.

Die Sensitivitätskodierung (SENSE) ist ein Verfahren der parallelen Bildgebung. Sie basiert auf der gleichzeitigen Signaldetektion mit mehreren Empfangsspulen. Die Empfangsspulen sind nebeneinander und nah an der Körperoberfläche platziert. Durch die Verwendung mehrerer Spulen kann die Datenaufnahmezeit verkürzt werden, da zusätzliche Ortsinformationen durch die entsprechende Spulenanordnung vorhanden sind. Diese werden zur Rekonstruktion der entstehenden Einfaltung genutzt (Preussmann et al. SENSE: Sensitivity Encoding for FAST MRI, Zürich, Schweiz: 1999).

Durch die Aufnahme von jeweils nur jeder zweiten, vierten oder achten Datenzeile der Datenlinien im k-Raum, verkürzt sich die Messzeit entsprechend (= SENSE-Faktor 2, 4 oder 8). Durch die Reduktion der Abtastdichte in der Phasenkodierungsrichtung wird das Bildfeld (= Field of View, FOV) um den entsprechenden Faktor verringert (Noll und Sutton; Role of parallel imaging in high field functional MRI. Michigan: Department of Biomedical Engeneering, 2011). In den Bildern führt die reduzierte Aufnahme zu einer typischen Einfaltung überstehender Bildanteile.

Herz-Kreislauferkrankungen sind die häufigsten Todesursachen weltweit. Im Jahr 2011 starben in Deutschland rund 41 Prozent der insgesamt 858.768 Todesfälle durch Herzinfarkt oder anderen Herz-Kreislauferkrankungen. Die kardiovaskuläre MR-Bildgebung ist ein Schnittbildgebungsverfahren, die das Herz ohne Verwendung von Röntgenstrahlen oder radioaktiven Substanzen in beliebiger Orientierung darstellen kann.

Die Magnetresonanztomographie (MRT) ist ein bildgebendes Verfahren. Die MRT des Herzens erfordert schnelle Bildgebungstechniken, um Bewegungsartefakte auf Grund der Herzbewegung zu minimieren und die Datenaufnahme innerhalb klinisch akzeptabler Zeiten durchführen zu können. Die Dauer einer einzelnen MR-Datenaufnahme hängt von der benötigten räumlichen und zeitlichen Auflösung der Bilder ab und kann sich über mehrere Herzschläge erstrecken.

Die anatomische MR Bildgebung des Herzens und thorakaler Gefäße erfolgt vorrangig mit Schwarzblut-MR-Bildgebungstechniken (black blood). Schwarzblut-MR-Techniken benutzen in der Regel sogenannte schnelle Spin-Echo-Techniken (engl.: FSE- Fast-Spin Echo). Diese zeichnen sich dadurch aus, dass nach einer Anregung ein Zug von Refokussierungspulsen die Magnetisierung refokussiert und diese unter Abklingen des Signals mehrfach unter Anwendung der Ortskodierung (techn.: Phasenkodierung) ausgelesen werden kann. FSE Techniken können sowohl als Einzelschussverfahren oder als segmentierte ausgelegt werden.

Bei der anatomischen Bildgebung des Herzens ist es notwendig, dass die untersuchte Person oder das untersuchte Lebewesen den Atem für die Datenaufnahme anhalten muss. Pro Atemanhaltphase werden ein oder mehrere Schnittbilder aufgenommen. Die 2D MRT Bildgebung benötigt etwa 10 Schnittbilder um das komplette Herz abzudecken. Dies führt zu langen Untersuchungszeiten von 8-14 Minuten. Deshalb die Notwendigkeit für Beschleunigung der Bildgebung. Z.B. würde ein Beschleunigungsfaktor 2 die Aufnahmezeit halbieren.

Alternativ kann die Bildgebung unter freier Atmung stattfinden. Zur Kompensation von Einflüssen der Atembewegung auf die Bildqualität werden Trigger- oder Navigatortechniken eingesetzt. Diese reduzieren den Wirkungsgrad beziehungsweise die Effizienz der Bildaufnahme und können deshalb ebenfalls von jeder Form der Beschleunigung beziehungsweise Verbesserung des Wirkungsgrades profitieren.

Eine Möglichkeit der Beschleunigung stellt die parallele Bildgebung dar. Dazu gehören Ansätze, die B1-Intensitätsprofile von HF-Spulen als supplementäre Form der Ortskodierung benutzen. Da parallele Bildgebung das NyquistTheorem verletzt, müssen geeignete Verfahren zur Entfaltung der unterabgetasteten Daten eingesetzt werden. Hierzu gehören der bildbasierte Rekonstruktionsansatz SENSE (Preussmann et al. SENSE: sensitivity encoding for fast MRI. Magnetic Resonance in Medicine, 1999. 42(5): p. 952-62) als auch der k-Raum Daten basierte Rekonstruktionsansatz SMASH (Sodickson und Manning, Simultaneous acquisition of spatial harmonics (SMASH): Fast imaging with radiofrequency coil arrays. Magnetic Resonance in Medicine, 1997. 38(4): p. 591-603) und GRAPPA (Griswold et al., Generalized Autocalibrating Partially Parallel Acquisitions (GRAPPA). Magnetic Resonance in Medicine, 2002. 47(6): p. 1202-1210). Beide Verfahren erfordern die Bestimmung der B1 Intensitätsprofile von Hochfrequenz (HF)-Spulen. Zur Erstellung dieser Referenzdaten werden in der Regel unbeschleunigte, niedrig aufgelöste, aber vollständig und mit regulärer Dichte abgetastete Daten aufgenommen. Diese Referenzdaten (engl. reference scan) können separat (engl. external reference scan) oder als Teil der beschleunigten Datenaufnahme (engl. self-calibration) durchgeführt werden.

Daneben gibt es Beschleunigungstechniken, in denen Daten entlang der Zeit- und Raumachse unterabgetastet werden, der sogenannte k-t Ansatz (k-t BLAST) (Tsao, Boesiger, and Pruessmann, k-t BLAST and k-t SENSE: Dynamic MRI with high frame rate exploiting spatiotemporal correlations. Magnetic Resonance in Medicine, 2003. 50(5): p. 1031-1042). Diese Techniken gelten naturgemäß nur für Zeitreihen. Die Rekonstruktion und Entfaltung dieser Daten erfolgt auf der Basis unbeschleunigter, räumlich niedrig aufgelöster aber vollständig abgetasteter Trainingsdaten, die die zeitlich-räumliche Beziehung der Daten einer Zeitserie erfassen. Die Trainingsdaten können separat oder zeitlich geschachtelt mit den unterabgetasteten Daten aufgenommen werden.

Zur Vermeidung von Misregistrierung zwischen Referenzdaten oder Trainingsdaten und dem beschleunigten Datensatz ist der Ansatz der Selbstkalibrierung dem externen Referenzscan vorzuziehen. Ebenso ist die zeitnahe beziehungsweise zeitlich geschachtelte Aufnahme von Trainingsdaten der separaten Aufnahme von Trainingsdaten vorzuziehen. Die zeitlich geschachtelte Aufnahme von Trainingsdaten kann jedoch zu einem größeren Zeitverlust führen, als die separate Aufnahme von Trainingsdaten. Für den klinischen Einsatz ist eine beschleunigte Bildgebung von Nöten um die Aufnahme in klinisch akzeptablen Zeiten durchführen zu können.

Es war Aufgabe der Erfindung ein Verfahren bereitzustellen, das nicht die Nachteile oder Mängel des Standes der Technik aufweist und mit dem eine beschleunigte Bildgebung erreicht wird.

### Beschreibung der Erfindung

Gelöst wird die Aufgabe durch den unabhängigen Anspruch. Bevorzugte Ausführungsformen der Erfindung ergeben sich aus den Unteransprüchen.

In einer ersten bevorzugten Ausführungsform betrifft die Erfindung ein Magnetresonanztomographie (MRT)-Verfahren, wobei
nach einer Grundanregung und einer Serie von Hochfrequenz-Refokussierungspulsen nach dem Spin-Echo Prinzip zwei Echogruppen entstehen, wobei
b) beide Echogruppen unabhängig voneinander phasenkodiert werden, und wobei
c) die Rekonstruktion für beide Echogruppen unabhängig voneinander erfolgt.

Dieses erfindungsgemäße Verfahren zeichnet sich besonders durch eine schnelle Spin-Echo MRT-Bildgebung aus. Die Erfindung fußt auf der Fast-Spin-Echo-Technik (FSE). In ihr wird bevorzugt nach einer Grundanregung ein Zug von Refokussierungspulsen und Datenaufnahmefenstern ausgeführt.

Im Stand der Technik wird zwar die Nutzung der Split-Echo Technik mit identischer Phasenkodierung und Rekonstruktion für beide Echogruppen beschrieben, aber beide Echogruppen werden nicht unabhängig voneinander betrachtet. Der Split-Echo Ansatz benutzt gleiche Phasenkodierung und Rekonstruktion für Echogruppe 1 und Echogruppe 2.

Die Erfindung nutzt insbesondere den Sachverhalt, dass in FSE Techniken Spin-Echos und stimulierte Echos entstehen. Je nach Zahl der Refokussierungspulse, die die jeweiligen Echogruppen erfahren, werden die Echogruppen bevorzugt in gerade und ungerade Echos klassifiziert. Diese erscheinen in der Basisvariante der FSE Technik in der Mitte des Datenaufnahmefensters und interferieren dort positiv miteinander.

Bei der Phasenkodierung handelt es sich im Sinne der Erfindung bevorzugt um ein Verfahren zur Definition der Zeilen der Messmatrix. Zwischen HF-Anregungspuls und Auslesung des MR-Signals wird kurzzeitig ein Magnetfeldgradient geschaltet, der den Spins von Zeile zu Zeile eine Phasenverschiebung aufprägt. Zur vollständigen Messung einer Schicht müssen je nach Matrix z.B. 256 oder 512 Phasenkodierschritte erfolgen. Die anschließende Fourier-Transformation kann die unterschiedlichen Phasenlagen wieder den ihnen entsprechenden Zeilen zuordnen.

### Bei der Refokussierung werden die Spins werden wieder in Phase gebracht

Mit Spin-Echo wird insbesondere das Wiedererscheinen des Magnetresonanz-Signals nach Zerfall des FID-Signals beschrieben. Hierzu wird die Dephasierung der Spins (Zerfall der Quermagnetisierung) durch Einstrahlen eines 180°-Inversionspulses aufgehoben. Die Spins geraten wieder in Phase, und es entsteht das Spinecho zum Zeitpunkt TE (Echozeit). Das FID-Signal, wird durch die HF-Anregung der Kernspins induziert und fällt ohne äußere Einwirkungen (frei) mit einer charakteristischen Zeitkonstanten T2* exponentiell ab.

Im Sinne der Erfindung kann die erste Echogruppe auch als Echo 1 (oder E1) und die zweite Echogruppe als Echo 2 (E2) bezeichnet werden.

In der derzeitigen klinischen Praxis werden Schwarzblut-MR-Bildgebungstechniken eingesetzt um (i) Bilder der Morphologie und Anatomie des Herzens und der großen Blutgefäße herzustellen, (ii) Ödeme zu detektieren, (iii) Amyloidose zu diagnostizieren und für (iv) T₂ Bewertung und Charakterisierung von Geweben. Diese Technik ist jedoch langsam. Das erfindungsgemäße Verfahren kann die Bildgebung erheblich schneller gestalten und daher bevorzugt in für die verschiedenen Schwarzblut-MR-Bildgebungstechniken eingesetzt werden.

Es ist bevorzugt, dass die unabhängige Phasenkodierung der Echogruppen durch die Implementierung unabhängiger Gradienten entlang der Phasenkodierungsrichtung erzielt wird.

Ein Gradient definiert Stärke und Richtung der Veränderung einer Größe im Raum. Ein magnetischer Feldgradient ist eine Änderung des Magnetfeldes in eine bestimmte Richtung, eine lineare Zunahme oder Abnahme. Die magnetischen Gradientenfelder werden mit Hilfe von Gradientenspulen erzeugt. Sie bestimmen beispielsweise die räumliche Auflösung im Bild.

Die Anwendung zusätzlicher Gradienten entlang der Leserichtung erlaubt die Differenzierung beider Echogruppen, so dass eine erste und eine zweite Echogruppe entstehen, wobei beide Echogruppen hinsichtlich Datenaufnahme, Phasenkodierung und Rekonstruktion unabhängig voneinander behandelt werden.

Bei dem im Stand der Technik offenbarten displaced UFLARE Ansatz geht eine Echogruppe verloren, da durch die Anwendung zusätzlicher Gradienten entlang der Leserichtung eine Echogruppe komplett aus dem Akquisitionsfenster geschoben wird (Niendorf, On the application of susceptibility-weighted ultra-fast low-angle RARE experiments in functional MR imaging. Magn Reson Med, 1999. 41(6): p. 1189-98; Norris, Ultrafast Low-Angle Rare - U-Flare. Magnetic Resonance in Medicine, 1991. 17(2): p. 539-542).

Im bekannten split-echo Ansatz erfahren beide Echogruppen die gleiche Phasenkodierung (Schick, SPLICE: Sub-second diffusion-sensitive MR imaging using a modified fast spin-echo acquisition made. Magnetic Resonance in Medicine, 1997. 38(4): p. 638-644). Nachteilig hierbei ist, dass beide Echogruppen unabhängig voneinander rekonstruiert werden. Zur Formung eines abschließenden Bildes werden die beiden Bildergebnisse der unabhängigen Rekonstruktion beider Echogruppen schlicht und einfach summiert. Sowohl für die Phasenkodierung als auch die Rekonstruktion erfahren im split-echo Ansatz beide Echogruppen Gleichbehandlung, was für die Bildgebung und insbesondere die Qualität und Schnelligkeit der Bildgebung als nachteilig angesehen werden kann.

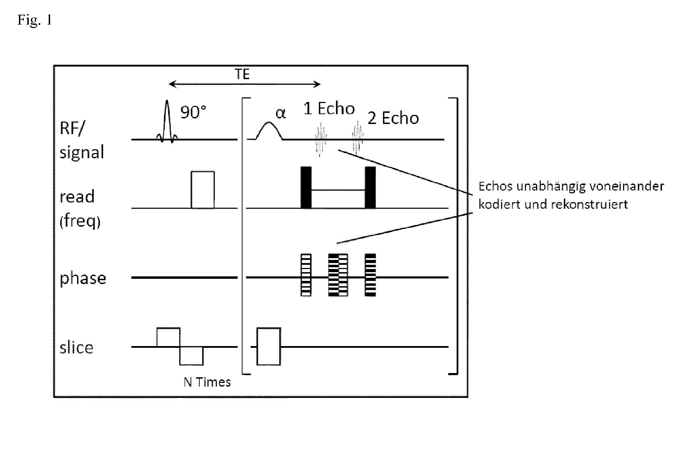

In der bevorzugten Ausführungsform der Erfindung erfahren beide Echogruppen (E1, E2) eine voneinander unabhängige Phasenkodierung und Rekonstruktion (siehe Fig. 1). So kann im Fall der parallelen beziehungsweise beschleunigten Bildgebung eine der beiden Echogruppen zur Aufnahme eines Referenzdatensatzes oder eine Trainingsdatensatzes benutzt werden, während die andere Echogruppe unterabgetastet aufgenommen wird. Die Erfindung ist somit vorteilhaft gegenüber dem Stand der Technik, da beide Echogruppen genutzt werden und durch die unterschiedliche Phasenkodierung zusätzliche Informationen liefern.

Die SCSE-FSE Technik ermöglicht es auch vorteilhafterweise Trainings- oder Referenzdaten mit einer höheren Auflösung und Qualität aufzunehmen, ohne zeitliche Kompromisse wie bei separaten oder konventionell selbst-kalibrierten Ansätzen mit niedriger Ortsauflösung eingehen zu müssen.

Besonders bevorzugt ist, dass eine der beiden Echogruppen zur Aufnahme eines Referenzdatensatzes oder eines Trainingsdatensatzes benutzt wird und die andere Echogruppe unterabgetastet aufgenommen wird.

Durch das Trennen der Echogruppen können der Referenzdatensatz zeitgleich mit den zu rekonstruierenden Daten aufgenommen und rekonstruiert werden. Es ist keine weitere Datenaufnahme notwendig um die Referenz-Map zu erstellen.

Vorteilhafterweise wird der Referenzdatenansatz (Referenzdaten) oder Trainingsdatenansatz (Trainingsdaten) mit einer höheren Auflösung und Qualität aufgenommen.

Es ist außerdem bevorzugt, dass der Referenzdatenansatz oder Trainingsdatenansatz zur Selbstkalibrierung genutzt wird.

In dieser bevorzugten Ausführungsform werden die Referenz- oder Trainingsdaten (E1) sehr zeitnah und nur mit wenigen Millisekunden Abstand zu den beschleunigten Daten (E2) aufgenommen. Dieser Ansatz kann daher zur Selbstkalibrierung genutzt werden. Deshalb kann die Erfindung auch insbesondere als selbst kalibrierte Split Echo FSE (SCSE-FSE) Technik bezeichnet werden. Die unterabgetasteten Daten (E2) können unter Ausnutzung der Referenzdaten mittels SENSE oder GRAPPA Ansatz aber auch mit jeder anderen Form von paralleler Bildgebung rekonstruiert werden. Ebenso gilt, dass zeitlich unterabgetastete Daten unter Ausnutzung regulär abgetasteter Trainingsdaten mittels k-t Ansatz oder jeder anderen Form von Rekonstruktionstechniken, die bevorzugt zeitlich-räumliche Beziehungen oder Redundanzen innerhalb einer Zeitserie ausnutzen, rekonstruiert werden können.

Das Verfahren ist vorzugsweise ein selbstkalibrierender Ansatz für die Aufnahme von Referenzdaten für die parallele Bildgebung. Ein Vorteil ist, dass dadurch die für externe Referenzdaten übliche Empfindlichkeit gegenüber Missregistrierungen von Objektpositionen, Organpositionen oder die Artefaktanfälligkeit auf Grund von Bewegung zwischen der Aufnahme der Referenzdaten und der beschleunigten Daten entfällt. Die Messungen werden dadurch genauer und aussagekräftiger.

Die für selbstkalibrierende Ansätze typische Eigenschaft der Aufnahme regulär abgetasteter zentraler k-Raumdaten als Referenzdaten und peripher unterabgetasteter k-Raumdaten als beschleunigte Daten entfällt. Bei dem bevorzugten Verfahren werden Referenzdaten und beschleunigte Daten bevorzugt nahezu zeitlich synchron, aber unabhängig voneinander aufgenommen. Damit hat das bevorzugte Verfahren einen Geschwindigkeitsvorteil beziehungsweise bei gleicher Geschwindigkeit einen Signal-Rausch-Vorteil.

Im Sinne der Erfindung die Achsen der Rohdatenmatrix, welche man üblicherweise kₓ und k_{y} nennt, die Matrix in vier Quadranten. Die durch die beiden Achsen aufgespannte Ebene nennt man auch Fourierraum oder k-Raum.

Durch die unabhängige Phasenkodierung beider Echogruppen verdoppelt sich die effektive Datenaufnahmerate. Der Verlust im Signal-Rausch-Verhältnis der einzelnen Echogruppen im Vergleich zum konventionellen Ansatz können leicht durch den Einsatz von Beschleunigungs- und Rekonstruktionstechniken ausgeglichen werden und bietet somit einen Geschwindigkeitsvorteil.

Der Referenzdatenansatz kann im Sinne der Erfindung auch als Referenzdaten und der Trainingsdatenansatz als Trainingsdaten bezeichnet werden.

Es ist weiterhin bevorzugt, dass die Echogruppen zur Erzeugung von Bildern mit unterschiedlichen Kontrasten oder Bildern mit gleichen Kontrasten mit unterschiedlich starken Wichtungen verwendet werden.

Durch die geeignete Wahl von Vorbereitungsexperiment und Auslese der Echogruppen 1 und 2 können Bilder mit unterschiedlicher Kontrastgewichtung erzeugt werden.

Des Weiteren ist bevorzugt, dass eine Echogruppe zur Aufnahme eines Fettbildes benutzt wird und die andere Echogruppe zur Aufnahme eines Wasserbildes benutzt wird.

Ein reines Wasserbild stellt nur den Signalanteil der an Wasser gebundenen Protonen im Bild dar und unterdrückt den Fettanteil.

Ein reines Fettbild stellt nur den Signalanteil der an Fett gebundenen Protonen im Bild dar und unterdrückt den Wasseranteil.

Durch diese Ausführungsform der Erfindung können MRT-Verfahren schneller durchgeführt werden, was eine bessere zeitliche Auslastung der teueren Geräte bedeutet und somit kostensparend ist.

Bei Gradientenecho-Sequenzen kann es durch die Chemische Verschiebung zu Phasenauslöschungen im Bild kommen. Ursache sind die leicht unterschiedlichen Resonanzfrequenzen von Fett und Wasser, die zu einer Phasenverschiebung innerhalb eines fett-/wasserhaltigen Voxels führen. Im Gegenphase-Bild sind Konturenartefakte deshalb an Grenzflächen von fett- und wasserhaltigem Gewebe in der Breite eines Voxels möglich. Diese chemische Verschiebung, auch chemical shift effect genannt, kann für das erfindungsgemäße Verfahren ausgenutzt werden.

Es ist außerdem bevorzugt, dass eine Echogruppe eine kartesische Form der Phasenkodierung erfährt, während die andere Echogruppe nicht-kartesische Formen der Phasenkodierung, bevorzugt spiralenförmige, radiale oder andere willkürliche Formen von k-Raumtrajektorien erfährt.

Es ist ebenfalls bevorzugt, dass eine Echogruppe eine kartesische Form der Phasenkodierung erfährt, während die andere Echogruppe insbesondere nicht-kartesische Formen der Phasenkodierung, wie bevorzugt spiralenförmige, radiale oder andere willkürliche Formen von k-Raumtrajektorien erfährt und umgekehrt.

Außerdem bevorzugt ist, dass eine Echogruppe unterabgetastet wird und mittels paralleler Bildgebung, bevorzugt SENSE oder GRAPPA rekonstruiert werden.

Bei SENSE (Sensitivity Encoding) wird die PAT-Rekonstruktion nach der Fourier-Transformation durchgeführt.

GRAPPA (Generalized Autocalibrating Partially Parallel Acquisition) ist eine Weiterentwicklung von SMASH mit Auto-Kalibrierung und einem modifizierten Algorithmus für die Bildrekonstruktion.

Es bei dieser Ausführungsform bevorzugt, dass Daten der unterabgetasteten Echogruppe unter Ausnutzung des Referenzdatenansatzes oder Trainingsdatenansatzes mittels paralleler Bildgebung, insbesondere SENSE oder GRAPPA, rekonstruiert werden. Der Fachmann weiß, dass für die Rekonstruierung der Daten bekannte Verfahren der parallelen Bildgebung verwendet werden können.

Im Gegensatz zur herkömmlichen SENSE-Rekonstruktion wird in dem bevorzugten erfindungsgemäßen Verfahren mit zwei unterschiedlichen Datensätzen gearbeitet. Durch das Trennen der Echos kann die Referenz-Map zeitgleich mit den zu rekonstruierenden Daten aufgenommen und rekonstruiert werden. Es ist keine weitere Datenaufnahme notwendig um die Referenz-Map zu erstellen. Das Bild verliert durch das Trennen der Echos von jeder k-Raumzeile zwar an Auflösung. Der Verlust entsteht aber in der Frequenzkodierrichtung, was sich leicht kompensieren lässt. Die Sequenz kann ohne großen zeitlichen Verlust von 256 x 256 auf 256 x 512 umgestellt werden.

Es ist weiterhin bevorzugt, dass die unterabgetastete Echogruppe unter Ausnutzung regulär abgetasteter Trainingsdaten mittels k-t Ansatz oder jeder anderen Form von Rekonstruktionstechniken rekonstruiert werden.

Bevorzugt ist auch, dass eine Echogruppe als Navigatorecho oder Phasenecho zur Aufzeichnung von Bewegung oder Bewegungszuständen verwendet wird, während die andere Echogruppe zur Erhebung von Bilddaten dient.

Bei einem Navigatorecho handelt es sich insbesondere um ein zusätzliche Spin- oder Gradientenecho zur Detektion von Positionsänderungen eines Objekts im Messvolumen oder von sonstigen Veränderungen.

Es ist auch bevorzugt dass eine Echogruppe benutzt wird, um bestimmte Segmente des k-Raumes abzutasten während die andere Echogruppe andere Segmente des k-Raumes abtastet. Hierdurch wird die Qualität der Bildgebung verbessert.

Es ist weiterhin bevorzugt, dass die erste Echogruppe eine ungerade Echogruppe und die zweite Echogruppe eine gerade Echogruppe darstellt.

Im Gegensatz zum Stand der Technik, ist es für das erfindungsgemäße Verfahren bevorzugt, dass hinsichtlich Datenaufnahme, Phasenkodierung und Rekonstruktion beide Echogruppen unabhängig voneinander behandelt werden. Die Erfindung hat zahlreiche Vorteile gegenüber dem Stand der Technik. So können die Daten vorteilhafterweise mit jeglicher parallelen Bildgebung rekonstruiert werden, z. B. SENSE. Für SENSE-Datensätze ist eine SENSE-Rekonstruktion empfehlenswert. Ein vollständiges Bild wird aus einer Anzahl der Einzelspulenbilder (Referenz-Map) und einem reduzierten FOV erstellt.

### Beispiele

Die Erfindung soll im Folgenden anhand von Beispielen und Abbildungen erläutert werden, ohne jedoch auf diese beschränkt zu sein.

### Beispiel 1:

Als Ausführungsbeispiel wird der selbstkalibrierte Split-Echo Ansatz (SCSE FSE) in einer bevorzugten Ausführung aufgeführt. Hierbei fungiert Echo 1 als Referenzdatensatz, mit dem das Intensitätsprofil von HF-Spulenarrays erhoben werden kann. Echogruppe 2 fungiert als unterabgetasteter Datensatz. Der Datensatz aus Echogruppe 2 kann unter Ausnutzung der Referenzdaten aus Echogruppe 1 entfaltet und rekonstruiert werden.

Zur Umsetzung wurden unabhängige Gradienten entlang der Phasenkodierungsrichtung generiert, um gerade und ungerade Echogruppen zu separieren und unabhängig voneinander zu kodieren. Eine Echogruppe dient der Referenz-Map (siehe Fig. 3). Somit wird ein externer Referenz-Scan überflüssig. Die andere Echogruppe dient als unterabgetasteter Datensatz (siehe Fig. 4). Dieser wird mit Hilfe der Referenz-Map entfaltet. Figur 5 zeigt ein vollständig rekonstruiertes Bild.

Die SCSE-FSE Sequenz wurde unter Verwendung von Beschleunigungsfaktoren von bis zu R=4 erfolgreich durchgeführt. Höhere Beschleunigungsfaktoren können ebenfalls erzielt werden. Konkret wurden in der Implementierung 18 Herzschläge benötigt, um mit der herkömmlichen FSE Sequenz ein Schnittbild aufzunehmen. Zum Vergleich wurden mit der SCSE-FSE Ansatz nur 5 Herzschläge bei einem Beschleunigungsfaktor von R=4. benötigt. Die SCSE-FSE Technik hat keinen Einfluss auf Blut-Unterdrückung. Der Einsatz der vorgeschlagenen Technik beschränkt sich nicht auf die MRT des Herzens, sondern kann auf alle beliebigen Organe, Lebewesen, Objekte ausgedehnt werden.

### Beispiel 2: Herz-Datensatz für selbstkalibrierte Split-Echo Fast Spin-Echo Bildgebung

Im Folgenden wird das Splitecho am Beispiel des Herzens rekonstruiert. Bei der Rekonstruktion des herkömmlichen SENSE-Algorithmus entstehen, durch den Versatz der Echos in jeder k-Raumzeile, Interferenzmuster die im Bild zu erkennen sind. Durch die Verarbeitung der Rohdaten ist es möglich, die Echos in der Mitte jeder k-Raumzeile zu trennen. Ein Datensatz dient als Referenz-Map. Die 32 Einzelspulenbilder haben eine Auflösung von 270 x 256 Pixel. Der andere Datensatz dient dem reduzierten FOV. Nachdem der FOV-Datensatz interpoliert wurde, durchlaufen beide Datensätze den Algorithmus (SENSE-Rekonstruktion). Das Ergebnisbild hat eine Auflösung von 270 x 256 Pixel. Es konnte so ein Bild ohne Einfaltungsartefakte rekonstruiert werden.

Für die SENSE-Rekonstruktion wird die Referenz-Map zeitgleich mit dem zu rekonstruierenden Datensatz erzeugt. Die beiden Datensätze enthalten unterschiedliche Informationen und stehen für die Rekonstruktion zur Verfügung. Eine zusätzliche Datenaufnahme für die Referenz-Map ist nicht mehr erforderlich. Es wurde mit Erfolg ein vollständiges Bild rekonstruiert.

### Beispiel 3:

Es wurde eine selbst-kalibrierte Split Echo FSE-Technik mit folgenden Daten umgesetzt:
Matrixgröße = 512x526
Echo-Pluszug-Länge: 16
Zahl der Dummy-Echos: 8
in-plane resolution: (1,3 x 1,3) mm²
Schichtdicke: 5 mm
TE: 67 ms
Repetitionszeit (Time to Repetitio = TR): 1 RR-Interval
Zeit zwischen den individuellen 180° Refokussierungspulse: 4,19 ms
Bandbreite ± 673 Hz/pixel

Durch zusätzliche Gradienten entlang der Leserichtung wurden gerade und ungerade Echogruppen getrennt. Beide Echogruppen wurden unterschiedlich phasenkodiert. Mit einer Echogruppe wurden Referenz-Scans erstellet, um eine Sensitivität Karte für die Spulen zu generieren. Dieser Ansatz benötigt daher keine externen Referenz-Scans und kann somit als selbstkalibrierend bezeichnet werden. Die zweite Echogruppe wurde verwendet um einen unterabgetasteten Datensatz zu erzeugen. Es wurden Beschleunigungsfaktoren von R= 2 bis R=4 verwendet. Das SCSE-FSE bildgebende Modul wurde mit double IR (double inversion recovery) für die Unterdrückung des Blutanteils und triple IR für die Unterdrückung des Blut/Fett-Anteils.

Die Bildgebung wurde mit einem 3.0 T whole body system (Siemens Verio, Siemens Healthcare, Erlangen, Deutschland) und einer Körperspule für TX und einem 32-Kanal-Kardiospulen Array (IN VIVO Corp., Gainsville, USA) für RX. Die Daten-Acquisition wurde während der Diastole durchgeführt. Die SENSE Rekonstruktion wurde durchgeführt um die unterabgetasteten Datensätze zu entfalten.

### Beispiel 4:

Zwei Datensätze werden mit Hilfe der Einlesefunktion erzeugt: Referenz-Map und reduziertes FOV. Für die Datenaufnahme wurde ein kugelförmiges Phantom verwendet. Durch den Reduktionsfaktor von zwei wird nur jede zweite k-Raumzeile aufgenommen. Es kommt zu Einfaltungen im Bildbereich. Nachdem das reduzierte FOV erstellt wurde, erfolgt eine Interpolation zu einem vollständigen FOV. Es wird die originale Matrixgröße wiederhergestellt und kann mit der Referenz-Map und dem Reduktionsfaktor den SENSE-Algorithmus durchlaufen.

Mit Hilfe des vollständigen FOV wird mit der Funktion "pmri_sample_vector" ein Abtastvektor des k-Raums erstellt. Die Funktion "pmri_prep" benötigt diesen Abtastvektor, die Referenz-Map und das reduzierte FOV. Diese Funktion dient zur Aufbereitung der Daten für die SENSE-Rekonstruktion. Die Daten werden geglättet und interpoliert. Als Ausgabe erzeugt die Funktion: ein transformiertes und eingefaltetes Einzelspulenbild, ein Empfindlichkeitsprofil der Einzelspulenbilder, eine Kovarianzmatrix.

Abschließend erfolgt die SENSE-Rekonstruktion mit der "pmri_core" Funktion. Das Bild wurde mit dem SENSE-Verfahren zu einem vollständigen Bild rekonstruiert.
Figur 1 zeigt exemplarisch eine bevorzugte Ausführungsform der selbst kalibrierten Split Echo FSE (SCSE-FSE) Technik. Beide Echogruppen werden unabhängig voneinander phasenkodiert und rekonstruiert. Die Zentren der Echos liegen in dieser Implementierung etwa bei 1/4 und 3/4 des Akquisitionsfensters, können jedoch in ihrer Lage im Akquisitionsfenster beliebig gewählt werden solange sie nicht miteinander interferieren. Im Gegensatz zur herkömmlichen FSE Sequenz, werden die geraden und ungeraden Echogruppen getrennt und unabhängig Phasenkodiert.

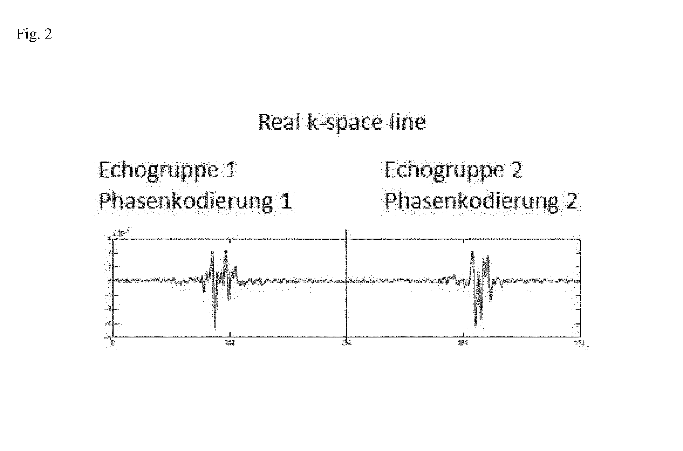

Figur 2 zeigt einen vergrößert Ansicht einer k-Raumzeile, um die Trennung der beiden Echogruppen zu illustrieren. Eine Echogruppe wird für die Spulen Sensitivität Karte generiert (sensitivity map). Die andere Gruppe wird verwendet, um unterabgetastete Daten zu generiere. Somit dient eine Echogruppe dem Referenzdatensatz (links) die zweite Echogruppe dient dem beschleunigtem Datensatz (rechts). Die Echogruppen können ebenfalls als Radiale Phasenkodierung links und Spirale Phasenkodierung recht, Navigator links und Bilddatensatz oder Segment 1 k-Raum links und Segment 2 k-Raum rechts verwendet werden.

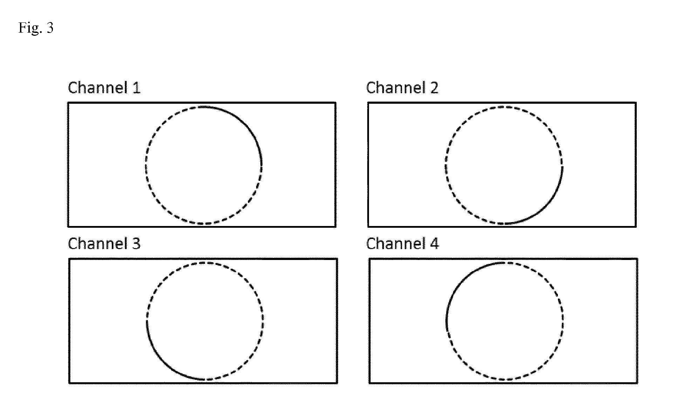

Figur 3 zeigt die Referenz-Map der linken Echogruppe bei einer vier Kanalspule. Dargestellt wird ein Phantom. Die Abbildung zeigt das Sensitivitätsprofil der einzelnen Spulen. Die durchgezogenen Linien stellt die höchste Signalintensität dar.

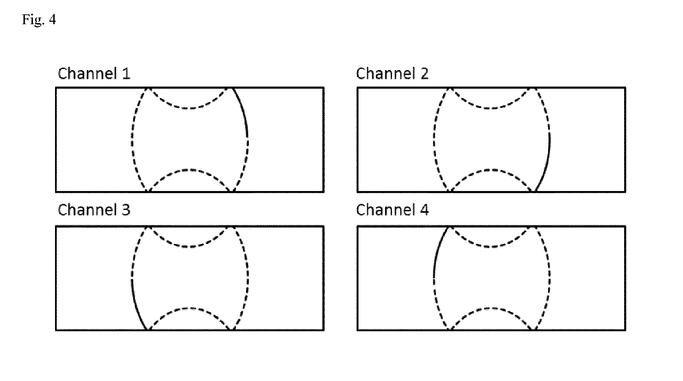

Figur 4 zeigt ein reduziertes FOV der rechten Echogruppe mit dem Beschleunigungsfaktor R=2. Die Abbildung stellt die 4 Einzelspulenbilder dar. Durch die Aufnahme von jeweils nur jeder 2 k-Raum Zeile kommt es zu Einfaltungen im Bildbereich. Mit Hilfe der Referenz-Map kann mit einem linearen Gleichungssystem das Bild entfaltet und zu einem vollständigen Bild rekonstruiert werden.

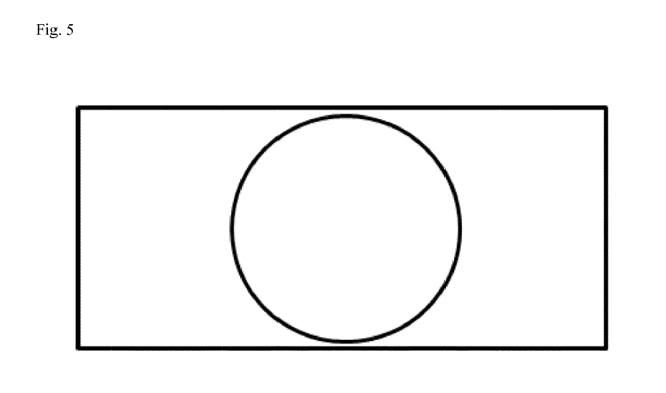

Figur 5 zeigt ein vollständig rekonstruiertes Bild mit Beschleunigungsfaktor R=2. Das Bild wurde mit zwei unabhängigen Echogruppen rekonstruiert.

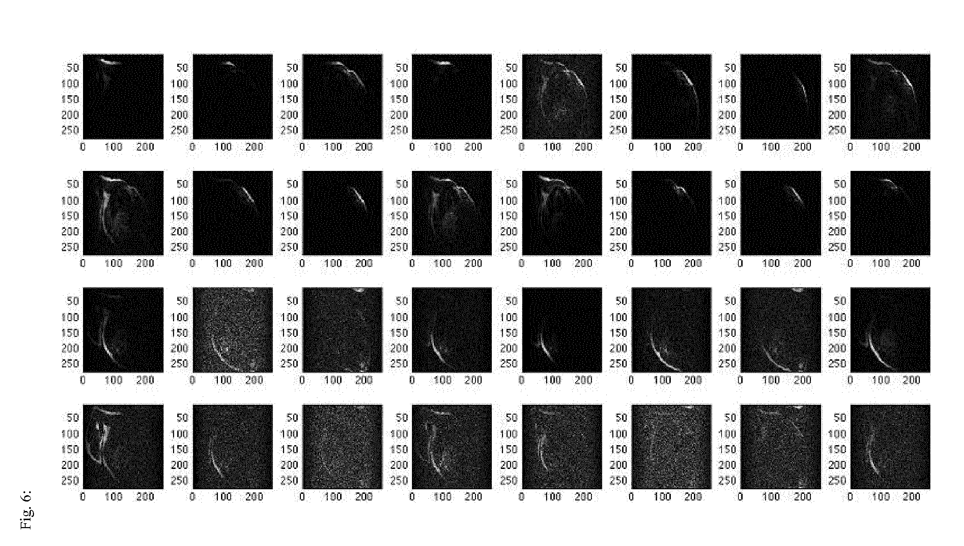

Figur 6 zeigt ein erstelltes Empfindlichkeitsprofil am Beispiel des Herzens. Hierzu wurden durch geeignete Verarbeitung der Rohdaten die Echos in der Mitte jeder k-Raumzeile getrennt. Der linke Datensatz diente als Referenz-Map für das Empfindlichkeitsprofil. Die gezeigten 32 Einzelspulbilder haben eine Auflösung von 270 x 256 Pixel.

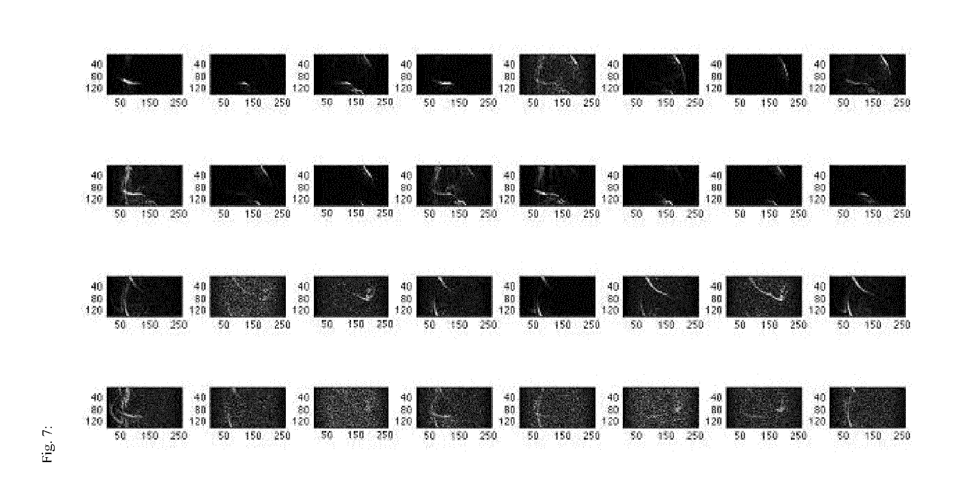

Figur 7 zeigt ein reduziertes FOV des Herzens. Hierzu wurde der rechte Datensatz verwendet. Es wird die Einfaltung im Bildbereich der jeweiligen Spulen mit einem Reduktionsfaktor von zwei gezeigt.

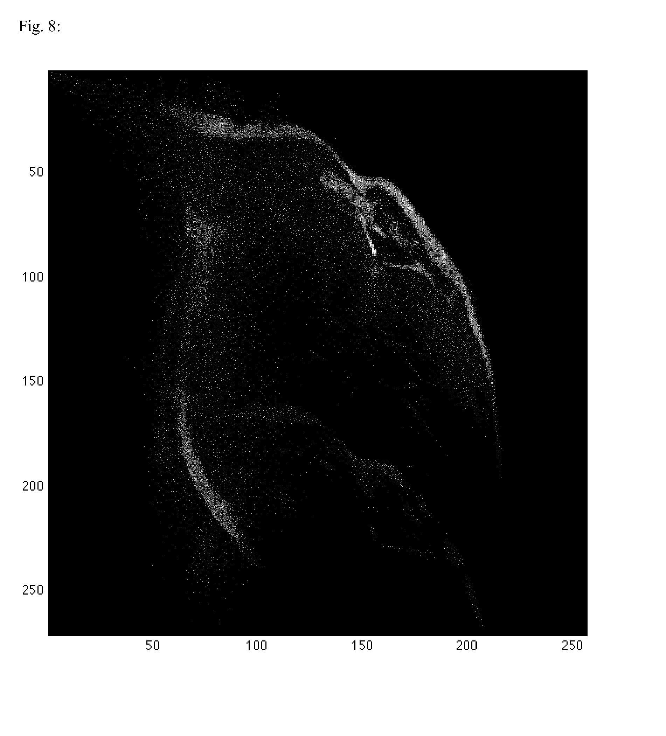

Figur 8 zeigt das Ergebnis nachdem der rechte Datensatz interpoliert wurde und beide Datensätze den Algorithmus der SENSE Rekonstruktion durchlaufen haben. Das Bild hat eine Auflösung von 270 x 256 Pixel und konnte ohne Einfaltungsartefakte rekonstruiert werden.

## Patentansprüche

1. Magnetresonanztomographie-Verfahren, wobei
a) nach einer Grundanregung und einer Serie von Hochfrequenz-Refokussierungspulsen nach dem Spin-Echo Prinzip zwei Echogruppen entstehen, wobei
b) beide Echogruppen unabhängig voneinander phasenkodiert werden, und wobei
c) die Rekonstruktion für beide Echogruppen unabhängig voneinander erfolgt.

2. Verfahren nach Anspruch 1, wobei
die unabhängige Phasenkodierung der Echogruppen durch die Implementierung unabhängiger Gradienten entlang der Phasenkodierungsrichtung erzielt wird.

3. Verfahren nach Anspruch 1 oder 2, wobei
eine der beiden Echogruppen zur Aufnahme eines Referenzdatensatzes oder eines Trainingsdatensatzes benutzt wird und die andere Echogruppe unterabgetastet aufgenommen wird.

4. Verfahren nach dem vorherigen Anspruch, wobei
der Referenzdatenansatz oder Trainingsdatenansatz zur Selbstkalibrierung genutzt wird.

5. Verfahren nach Anspruch 1 oder 2, wobei
die Echogruppen zur Erzeugung von Bildern mit unterschiedlichen Kontrasten oder Bildern mit gleichen Kontrasten mit unterschiedlich starken Wichtungen verwendet werden.

6. Verfahren nach Anspruch 1, 2 oder 5, wobei
eine Echogruppe zur Aufnahme eines Fettbildes benutzt wird und die andere Echogruppe zur Aufnahme eines Wasserbildes benutzt wird.

7. Verfahren nach mindestens einem Ansprüche 1, 2, 5 oder 6, wobei
eine Echogruppe eine kartesische Form der Phasenkodierung erfährt, während die andere Echogruppe nicht-kartesische Formen der Phasenkodierung, bevorzugt spiralenförmige, radiale oder andere willkürliche Formen von k-Raumtrajektorien erfährt.

8. Verfahren nach mindestens einem der vorhergehenden Ansprüchen, wobei
eine Echogruppe unterabgetastet wird und mittels paralleler Bildgebung, bevorzugt SENSE oder GRAPPA rekonstruiert werden.

9. Verfahren nach einem oder mehreren der vorherigen Ansprüche, wobei
die unterabgetastete Echogruppe unter Ausnutzung regulär abgetasteter Trainingsdaten mittels k-t Ansatz oder jeder anderen Form von Rekonstruktionstechniken rekonstruiert wird.

10. Verfahren nach mindestens Anspruch 1 oder 2, wobei
eine Echogruppe als Navigatorecho oder Phasenecho zur Aufzeichnung von Bewegung oder Bewegungszuständen verwendet wird, während die andere Echogruppe zur Erhebung von Bilddaten dient.

11. Verfahren nach Anspruch 1 oder 2, wobei
eine Echogruppe benutzt wird, um bestimmte Segmente des k-Raumes abzutasten während die andere Echogruppe andere Segmente des k-Raumes abtastet.

12. Verfahren nach mindestens einem der vorherigen Ansprüche, wobei
die erste Echogruppe eine ungerade Echogruppe und die zweite Echogruppe eine gerade Echogruppe darstellt.
